# EUROPEAN PATENT APPLICATION

(11) **EP 4 753 392 A1**
(43) Date of publication of application: **03.06.2026**
(21) Application number: 24845133.8
(22) Date of filing: 24.04.2024
(51) Int. Cl.: H05K 9/00, B32B 27/18

(54) **ELECTROMAGNETIC NOISE SUPPRESSION SHEET, METHOD FOR MANUFACTURING SAME, AND CABLE USING ELECTROMAGNETIC NOISE SUPPRESSION SHEET**

(30) Priority: 27.07.2023 JP 2023122620
(71) Applicant: Maxell, Ltd., Kyoto 618-8525 (JP)
(72) Inventor: MIZUTANI, Takuo, Oyamazaki Otokuni-gun, Kyoto 618-8525 (JP); HIROI, Toshio, Oyamazaki Otokuni-gun, Kyoto 618-8525 (JP); TERASAWA, Makoto, Oyamazaki Otokuni-gun, Kyoto 618-8525 (JP)
(74) Representative: Mewburn Ellis LLP
(86) International application number: PCT/JP2024/016024
(87) International publication number: WO 2025/022748

(57) **Abstract**

An electromagnetic noise suppression sheet according to the present application includes a base and a magnetic layer, the magnetic layer contains a magnetic material and a binder, and the binder contains an amorphous resin (A) having a glass transition temperature of -50°C to 0°C and an amorphous resin (B) having a glass transition temperature of 10°C or higher. The amorphous resin (A) is preferably an amorphous polyester (a) having a glass transition temperature of -50°C to 0°C, and the amorphous resin (B) is preferably an amorphous polyester (b) having a glass transition temperature of 10°C or higher.

## Description

### Technical Field

The present application relates to an electromagnetic noise suppression sheet that absorbs electromagnetic waves in the kHz to GHz band.

### Background Art

With the development of wireless communication technology typified by mobile phones, various devices and sensors are becoming connected to networks wirelessly. Also, in the medical field, from the viewpoint of preventing infection, devices are increasingly becoming cordless, and medical devices are beginning to be connected wirelessly. These communications require high speed and a large capacity over relatively short distances, and use high frequencies. As the number of devices using such high frequencies increases, there is an increasing risk that failure will occur in electronic devices and communication due to malfunction caused by electromagnetic noise generated from the devices or interference with the electromagnetic waves being used. Furthermore, in recent years, millimeter wave radar has begun to be installed for the purpose of preventing automobile collisions. Failure in these devices in the medical and automotive fields has an impact on human life, and therefore malfunctions must not occur. In view of this, it is increasingly necessary to apply electromagnetic noise suppression sheets to circuit elements and transmission lines that emit and receive electromagnetic waves in the kHz to GHz band as a so-called EMC (Electromagnetic Compatibility) countermeasure to prevent failure caused by electromagnetic noise from devices and interference caused by the noise.

In such circumstances, Patent Document 1 proposes the use of a laminate of a magnetic layer containing magnetic powder and a binder resin and a film layer made of a polymer compound as a magnetic sheet that suppresses the transmission of electromagnetic waves. Since the binder resin used in the magnetic layer of the laminate in Patent Document 1 contains a crystalline polyester resin, it is possible to realize a laminate with excellent strength and no tack. On the other hand, when the magnetic layer contains the crystalline polyester resin, the crystallinity of the binder resin increases during a drying process in the manufacturing of the magnetic layer, which hardens the magnetic layer. Thus, if the above laminate is used as a magnetic sheet by wrapping the laminate around a cable or connector, cracks may form in the magnetic layer. In addition, if the magnetic layer contains the crystalline polyester resin, the adhesion between the magnetic layer and the film layer made of a polymer compound may decrease, which may cause the magnetic layer and the film layer made of a polymer compound to peel off from each other.

Also, Patent Document 2 is an example of prior technique documents related to use of an electromagnetic noise suppression sheet according to the present application. Patent Document 2 discloses a communication cable in which a magnetic sheath layer, in which a particulate magnetic material is dispersed in a polymer material, is formed as a molded body obtained through extrusion molding.

### Prior Art Documents

### Patent Documents

[Patent Document 1] JP 2016-36965A (Japanese Patent No. 6428033)
[Patent Document 2] JP 2022-108557A

### Disclosure of Invention

### Problem to be Solved by the Invention

The present application solves the above problems and provides an electromagnetic noise suppression sheet that can be used by being applied to an uneven surface or a curved surface of an electronic device that requires protection from an influence of electromagnetic noise, or being wrapped around a cable or a connector in particular, and that has an electromagnetic-wave absorbing capacity in the kHz to GHz band.

### Means for Solving Problem

An electromagnetic noise suppression sheet according to the present application includes: a base; and a magnetic layer, wherein the magnetic layer contains a magnetic material and a binder, and the binder contains an amorphous resin (A) having a glass transition temperature of -50°C to 0°C and an amorphous resin (B) having a glass transition temperature of 10°C or higher.

A method for manufacturing an electromagnetic noise suppression sheet according to the present application is a method for manufacturing the electromagnetic noise suppression sheet according to the present application, the method including: a step of producing a coating material for forming a magnetic layer by mixing, together with a solvent, a magnetic material, an amorphous resin (A) having a glass transition temperature of -50°C to 0°C, and an amorphous resin (B) having a glass transition temperature of 10°C or higher; and a step of applying the coating material for forming a magnetic layer to the base and drying the coating material.

A cable according to the present application includes the electromagnetic noise suppression sheet of the present application.

### Effects of the Invention

According to the present application, it is possible to provide an electromagnetic noise suppression sheet that can be used by being attached to an uneven or curved surface of an electronic device, or wrapped around a cable or a connector, and has an electromagnetic-wave absorbing capacity in the kHz to GHz band.

### Brief Description of Drawings

[FIG. 1] FIG. 1 is a schematic cross-sectional view showing an example of an electromagnetic noise suppression sheet according to an embodiment.
[FIG. 2] FIG. 2 is a schematic cross-sectional view showing another example of the electromagnetic noise suppression sheet according to an embodiment.
[FIG. 3] FIG. 3 is a schematic cross-sectional view showing an example of a conventional coaxial cable.
[FIG. 4] FIG. 4 is a schematic cross-sectional view showing an example of a coaxial cable according to an embodiment.

### Description of the Invention

### (Electromagnetic noise suppression sheet)

An embodiment of an electromagnetic noise suppression sheet according to the present application will be described. The electromagnetic noise suppression sheet according to this embodiment includes a base and a magnetic layer. The magnetic layer contains a magnetic material and a binder, and the binder contains an amorphous resin (A) having a glass transition temperature of -50°C to 0°C, and an amorphous resin (B) having a glass transition temperature of 10°C or higher.

In the electromagnetic noise suppression sheet according to the present application, the magnetic layer contains, as the binder, the amorphous resin (A) having a glass transition temperature of -50°C to 0°C, and an amorphous resin (B) having a glass transition temperature of 10°C or higher. Thus, the magnetic layer has excellent bending properties (flexibility) and adhesion, and even when the electromagnetic noise suppression sheet according to this application is wrapped around a cable or connector, no crack will form in the magnetic layer, and the magnetic layer will not peel off from the base.

Also, the amorphous resin (A) is particularly preferably an amorphous polyester (a) having a glass transition temperature of -50°C to 0°C, and the amorphous resin (B) is particularly preferably an amorphous polyester (b) having a glass transition temperature of 10°C or higher. The bending properties and adhesion of the magnetic layer can be further improved by using, as the binder for the magnetic layer, the amorphous polyester (a) having a glass transition temperature of -50°C to 0°C, and the amorphous polyester (b) having a glass transition temperature of 10°C or higher.

In general, when the glass transition temperature of an amorphous polyester is low, adhesion and flexibility are improved, but tackiness (adhesiveness) increases, whereas when the glass transition temperature of an amorphous polyester is high, tackiness decreases, but the surface of the magnetic layer becomes hard and flexibility decreases. Therefore, it is preferable to use, as the binder in this embodiment, an amorphous polyester (a) having a glass transition temperature of -50°C to 0°C and an amorphous polyester (b) having a glass transition temperature of 10°C or higher in combination. This makes it possible to realize an electromagnetic noise suppression sheet that has sufficient adhesion and flexibility and has suppressed tackiness.

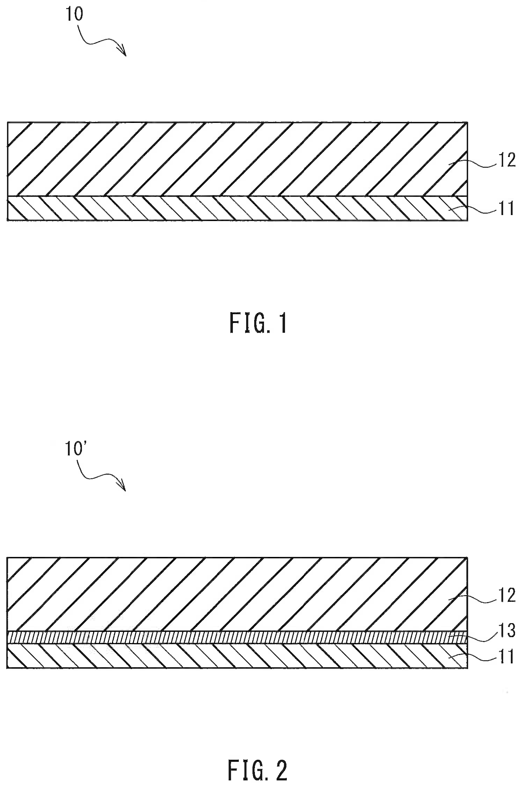

Hereinafter, the electromagnetic noise suppression sheet according to this embodiment will be described with reference to the drawings. FIG. 1 is a schematic cross-sectional view showing an example of the electromagnetic noise suppression sheet according to this embodiment. In FIG. 1, an electromagnetic noise suppression sheet 10 includes a base 11 and a magnetic layer 12 disposed on the base 11. Although the electromagnetic noise suppression sheet 10 has a two-layer structure consisting of the base 11 and the magnetic layer 12 in FIG. 1, the electromagnetic noise suppression sheet 10 may have a three-layer structure by further disposing an adhesive layer on the magnetic layer 12 side.

FIG. 2 is a schematic cross-sectional view showing another example of the electromagnetic noise suppression sheet according to this embodiment. In FIG. 2, an electromagnetic noise suppression sheet 10' includes a base 11, a metal layer 13 disposed on the base 11, and a magnetic layer 12 disposed on the metal layer 13. Although the electromagnetic noise suppression sheet 10' has a three-layer structure consisting of the base 11, the magnetic layer 12, and the metal layer 13 in FIG. 2, the electromagnetic noise suppression sheet 10' may have a four-layer structure by further disposing an adhesive layer on the magnetic layer 12 side.

An overall thickness of the electromagnetic noise suppression sheet according to this embodiment is preferably 10 to 85 µm, and more preferably 20 to 60 µm. This is because if the overall thickness of the electromagnetic noise suppression sheet is too small, the magnetic layer will also be thin, an electromagnetic-wave absorbing property will deteriorate, and the strength of the entire sheet will also decrease. This is also because if the overall thickness of the electromagnetic noise suppression sheet is too large, the flexibility will decrease, making it difficult to use the sheet by wrapping the sheet around a cable or a connector.

Next, constituent members of the electromagnetic noise suppression sheet according to this embodiment will be described.

### <Base>

The base used for the electromagnetic noise suppression sheet according to this embodiment is a base body for forming the magnetic layer.

The base may be any base as long as it has flexibility and can ensure adhesion to the magnetic layer, and a resin film is usually used as the base. Examples of the resin forming the base include polyolefin-based resins (such as polyethylene and polypropylene) and polyester resins (such as polyethylene terephthalate: PET, polyethylene naphthalate: PEN, polybutylene terephthalate: PBT, and polybutylene naphthalate: PBN), polyimide-based resins, polyamide-based resins, ethylene-vinyl acetate copolymers, ionomer-based resins, ethylene-(meth)acrylic acid copolymers, ethylene-(meth)acrylic acid ester copolymers, ethylene-butene copolymers, ethylene-hexene copolymers, polyurethane-based resins, polyetherketone-based resins, polyether-based resins, polyethersulfone-based resins, polystyrene-based resins (such as polystyrene), polyvinyl chloride-based resins, polyvinylidene chloride-based resins, polyvinyl alcohol-based resins, polyvinyl acetate-based resins, vinyl chloride-vinyl acetate copolymers, polycarbonate-based resins, fluorine-based resins, silicone-based resins, and cellulose-based resins, and examples of the base include any base made of these resins and crosslinked bodies of these resins. In particular, polyethylene terephthalate (PET) is more preferable in terms of mechanical characteristics and cost. One, or two or more of these resin materials can be used. In addition, the above resin material may, if necessary, have a functional group. A functional monomer or a modifying monomer may be grafted onto the resin material.

The surface of the base may be subjected to a known surface treatment to improve adhesion to the adjacent magnetic layer. Specifically, examples of the surface treatment include corona discharge treatment, ozone exposure treatment, high voltage shock exposure treatment, and ionizing radiation treatment. In addition, coating treatment with an undercoat agent (such as silicone treatment), primer treatment, matte treatment, crosslinking treatment, or the like may be applied to the base.

The substrate may be in the form of a single layer or a laminate of two or more layers. In addition, if necessary, known assistants such as a filler, a flame retardant, an anti-deterioration agent, an antistatic agent, a softener, and a plasticizer may be added.

The thickness of the base is not particularly limited, and is preferably 5 to 20 µm, and more preferably 10 to 15 µm. When the thickness of the base is in the above range, the electromagnetic noise suppression sheet of this embodiment can have both strength and flexibility.

The base may be any base as long as it has flexibility and can ensure adhesion to the magnetic layer, and thus, a metal layer such as a metal foil, which will be described later, can be used as the base, instead of the resin film. That is, a metal layer can also be used as the base 11 shown in FIG. 1.

### <Magnetic layer>

The magnetic layer used for the electromagnetic noise suppression sheet according to this embodiment contains a magnetic material and a binder. The thickness of the magnetic layer is not particularly limited. However, when the magnetic layer is too thin, an electromagnetic-wave absorption property will deteriorate, and when the magnetic layer is too thick, flexibility will decrease. Therefore, the thickness of the magnetic layer is usually set in the range of 5 to 70 µm. Hereinafter, constituent materials of the magnetic layer will be described.

### [Binder]

It is sufficient that the binder contains an amorphous resin (A) having a glass transition temperature of -50°C to 0°C and an amorphous resin (B) having a glass transition temperature of 10°C or higher. Amorphous resins are highly soluble in water and other solvents and have excellent dispersibility for magnetic materials (magnetic powder). Therefore, the magnetic layer can be formed into a sheet by dispersing magnetic powder in a resin dissolved in water or other solvent, applying the resulting mixture onto the base at a desired thickness, and drying the mixture on the base.

By using the amorphous resin (A) having a glass transition temperature of -50°C to 0°C, it is possible to impart greater flexibility to the magnetic layer and also improve the adhesion of the magnetic layer to the base. However, if only the amorphous resin (A) is used, the magnetic layer tends to become tacky (adhesive), and when magnetic sheets are stacked on each other or a magnetic sheet is wound in a roll, the magnetic layers may stick together. On the other hand, when only the amorphous resin (B) having a glass transition temperature of 10°C or higher is used, the surface of the magnetic layer will be hard and less likely to stick, but the adhesion between the magnetic layer and the base may decrease, or the magnetic layer may crack when the magnetic sheet is used by being wrapped around a cable or a connector. Therefore, the amorphous resins (A) and (B) are used together as the binder in this embodiment.

The upper limit of the glass transition temperature of the amorphous resin (B) having a glass transition temperature of 10°C or higher is preferably 100°C, and more preferably 80°C. If the glass transition temperature is higher than the upper limit, even when such an amorphous resin (B) is used in combination with an amorphous resin (A) having a glass transition temperature of -50°C to 0°C, the surface of the magnetic layer tends to become hard, and thus the adhesion between the magnetic layer and the base may decrease, or the magnetic layer may tend to crack when the magnetic sheet is attached to an uneven or curved surface or bent while being wrapped around a cable or a connector.

It is possible to use, as the amorphous resin (A), an amorphous polyester, amorphous polyurethane, amorphous acrylic resin, or the like having a glass transition temperature of -50°C to 0°C, and to use, as the amorphous resin (B), an amorphous polyester, amorphous polyurethane, amorphous acrylic resin, or the like having a glass transition temperature of 10°C or higher. In particular, the amorphous resin (A) is preferably an amorphous polyester (a) having a glass transition temperature of -50°C to 0°C, and the amorphous resin (B) is preferably an amorphous polyester (b) having a glass transition temperature of 10°C or higher. Among amorphous resins, amorphous polyester has excellent solubility and flexibility, and is suitable for manufacturing a sheet-shaped magnetic layer.

In the above viewpoints, a mass ratio between the amorphous polyester (a) and the amorphous polyester (b) is preferably (a):(b) = 95:5 to 35:65, and more preferably (a):(b) = 90:10 to 50:50. The mass ratio between the amorphous polyesters (a) and (b) can be estimated to some extent from the intensities of the two glass transition temperature peaks detected by measuring the glass transition temperature of the magnetic layer. The glass transition temperature can be measured by a differential scanning calorimeter (DSC).

Examples of the amorphous polyesters (a) and (b) include "VYLON" (registered trademark) manufactured by Toyobo, Co., Ltd., "PLAS COAT" (registered trademark) manufactured by Goo Chemical, Co., Ltd., "Nichigo-POLYESTER" (registered trademark) manufactured by Mitsubishi Chemical Group Corporation, and "ALMATEX" (registered trademark) manufactured by Mitsui Chemicals, Inc. These amorphous polyesters have excellent solubility in water and organic solvents, and can be used by dissolving them in water or an organic solvent at any ratio.

At least one of the amorphous polyester (a) and the amorphous polyester (b) preferably contains a crosslinked portion crosslinked by an amide bond. This can further improve the adhesion of the magnetic layer to the base. Usually, the amorphous polyesters (a) and (b) each have a carboxyl group at least at a molecular end and can optionally add a carboxyl group to a molecular chain. Thus, a crosslinked portion crosslinked by an amide bond can be formed by using a crosslinking agent having an oxazoline group or a carbodiimide group.

In addition to the amorphous resin (A) and the amorphous resin (B), the binder may contain at least one of a crystalline resin and an amorphous resin having a glass transition temperature of 0°C or more and less than 10°C, to an extent that effects of the present invention are not impaired. In this case, a total amount of the amorphous resin (A) and the amorphous resin (B) is preferably 90% by mass or more, and more preferably 95% by mass or more, relative to a total amount of the binder.

### [Magnetic material]

Although a soft magnetic material and a hard magnetic material can be used as the magnetic materials, it is preferable to use a soft magnetic material. Soft magnetic materials have a high initial magnetic permeability and can have an electromagnetic-wave absorbing capacity even when a small amount of a soft magnetic material is added to the magnetic layer. Thus, even when the thickness of the magnetic layer is reduced, electromagnetic noise suppression effects can be obtained.

Examples of the soft magnetic materials include iron, silicon iron, permalloy, sendust, permendur, soft ferrite, electromagnetic stainless steel, amorphous magnetic alloys, and nanocrystalline magnetic alloys, and carbonyl iron represented by Fe(CO)₅ is particularly preferable as a soft magnetic material. This is because carbonyl iron can have an electromagnetic-wave absorbing capacity (electromagnetic noise suppression effects) even in a relatively high frequency range such as the GHz band.

Examples of the hard magnetic materials include hard ferrite (ferrite magnet), an alnico magnet, a samarium-cobalt magnet, a neodymium magnet, and a samarium-iron-nitrogen magnet.

The above magnetic material is usually provided as spherical or flat powder, and the average particle size thereof is preferably 0.1 to 100 µm, and more preferably 1 to 20 µm. If the particle size of the above magnetic material is too small, the particles tend to undergo secondary aggregation, which makes it difficult to obtain a uniform coating film (magnetic layer). On the other hand, if the particle size is too large, particles will protrude from a magnetic layer as protrusions. Thus, the magnetic layer will tend to peel off from the base when the sheet is attached to an uneven or curved surface or wrapped around for use. In addition, if the particle size is large, the particles tend to settle when the magnetic material is used in a coating material, making it difficult to obtain a uniform coating film. The above average particle size can be measured using a laser diffraction scattering particle size distribution measurement device.

A volume content of the soft magnetic material contained in the magnetic layer is preferably 30% to 80%, and more preferably 40% to 70%. When the volume content is lower than 30%, the electromagnetic-wave absorbing capacity (electromagnetic noise suppression effects) of the magnetic layer tends to be insufficient. When the volume content exceeds 80%, the proportion of the binder in the magnetic layer decreases, the adhesion of the magnetic layer to the base decreases, and when the magnetic layer is bent, cracks tend to form and powder tends to fall off, for example.

### <Metal layer>

As shown in FIG. 2, by disposing a metal layer on the electromagnetic noise suppression sheet according to this embodiment, the electromagnetic noise suppression sheet can have an electric field shielding capacity, and it is possible to suppress not only magnetic noise but also electrical noise. Although the metal layer is disposed between the base and the magnetic layer in FIG. 2, the metal layer may be disposed on an outer surface of the magnetic layer.

There is no particular limitation on the types of metal that constitutes the metal layer as long as it has bending properties and adhesion to the magnetic layer, and aluminum, copper, and the like are preferable. This is because aluminum, copper, and the like are inexpensive, can be easily processed into a thin film, and have excellent bending properties.

There is no particular limitation on thickness of the metal layer. However, when the metal layer is too thick, flexibility will decrease. Therefore, the thickness of the metal layer is usually set in the range of 0.1 to 30 µm.

A metal foil can be used alone as the metal layer, or the metal layer can be formed by forming a metal thin film on the base (resin film) through vapor deposition or sputtering.

Further, as described above, the metal layer can also be used as the base 11 shown in FIG. 1.

### <Adhesive layer>

When an adhesive layer is disposed on the electromagnetic noise suppression sheet according to this embodiment, the thickness of the adhesive layer is preferably 10 to 50 µm, and more preferably 15 to 35 µm. If the above thickness is less than 10 µm, sufficient adhesive force may not be obtained. In addition, if the thickness exceeds 50 µm, the adhesion effect of the adhesive layer will be saturated and an overall thickness of the electromagnetic noise suppression sheet will increase, which will reduce flexibility of the electromagnetic noise suppression sheet, and thus will reduce conformability when the sheet is attached to an electronic component, or make it difficult to wrap the sheet around a wire or the like.

### (Method for manufacturing electromagnetic noise suppression sheet)

An embodiment of a method for manufacturing an electromagnetic noise suppression sheet according to the present application will be described. A method for manufacturing the electromagnetic noise suppression sheet according to this embodiment is the method for manufacturing the aforementioned electromagnetic noise suppression sheet according to the present application, and the method includes: a step of producing a coating material for forming a magnetic layer by mixing, together with a solvent, a magnetic material, an amorphous resin (A) having a glass transition temperature of -50°C to 0°C, and an amorphous resin (B) having a glass transition temperature of 10°C or higher; and a step of applying the coating material for forming the magnetic layer to the base and drying the coating material.

### <Coating material for forming magnetic layer>

The coating material for forming the magnetic layer can be produced by mixing, with a solvent, an amorphous resin (A) having a glass transition temperature of -50°C to 0°C and an amorphous resin (B) having a glass transition temperature of 10°C or higher. In general, amorphous resins have excellent coating material properties, and thus the magnetic layer can be easily formed on the base in an ordinary coating process by using the coating material for forming a magnetic layer.

The magnetic material mentioned above can be the same as the magnetic material that constitutes the magnetic layer of the electromagnetic noise suppression sheet according to the present application.

The resin materials that are the same as those forming the magnetic layer of the electromagnetic noise suppression sheet can be used for the amorphous resin (A) having a glass transition temperature of -50°C to 0°C and the amorphous resin (B) having a glass transition temperature of 10°C or higher.

At least one resin selected from the amorphous resin (A) having a glass transition temperature of -50°C to 0°C and the amorphous resin (B) having a glass transition temperature of 10°C or higher preferably contains a carboxyl group. As a result, by using a crosslinking agent, crosslinked portions can be formed in the amorphous resins (A) and (B).

As described above, an amorphous polyester has a carboxyl group at least at a molecular end, and a carboxyl group can be added to any molecular chain. Therefore, the amorphous resin (A) is particularly preferably an amorphous polyester (a) having a glass transition temperature of -50°C to 0°C, and the amorphous resin (B) is particularly preferably an amorphous polyester (b) having a glass transition temperature of 10°C or higher. Furthermore, amorphous polyesters are often water-soluble, and the magnetic materials mentioned above have good wettability with aqueous solvents. Therefore, the amorphous polyesters can be easily dispersed in an aqueous solvent together with the above magnetic material.

The crosslinking agent contained in the coating material for forming a magnetic layer is preferably a resin having at least one selected from an oxazoline group and a carbodiimide group. The oxazoline group and the carbodiimide group react with a carboxyl group to form an amide bond, and therefore, the amorphous polyester resins (a) and (b) can be crosslinked by an amide bond to form a crosslinked body. As a result, it is possible to further improve the adhesion of the formed magnetic layer and prevent the magnetic powder from falling off during the formation of the magnetic layer.

The crosslinking agent quickly reacts with carboxyl groups of the above amorphous polyester due to the heat in the drying process performed after the coating material for forming a magnetic layer is applied to the base, forming the crosslinked portions by amide bonds. On the other hand, cross-linked portions can be formed by epoxy bonds, urethane bonds, or the like. However, epoxy bonds, urethane bonds, and the like have a slow reaction rate for forming crosslinks, and thus in some cases, the crosslinking reaction may not be completed by the time of the drying process or the winding process after the coating material is applied to the base, and magnetic layers may stick together during the winding process and the subsequent aging process.

Examples of the resin having the oxazoline group include "EPOCROS" (registered trademark) manufactured by Nippon Shokubai Co., Ltd., and examples of the resin having the carbodiimide group include "CARBODILITE" (registered trademark) manufactured by Nisshinbo Chemical Inc.

It is desirable to use water as the solvent. The magnetic material has excellent water wettability and can be easily dispersed in water, achieving homogenization of the coating film containing the magnetic material, and improving the ability to fill the coating film with the magnetic material. In addition to water, water-soluble solvents such as ethyl alcohol, methyl alcohol, n-propyl alcohol, isopropyl alcohol, n-butyl alcohol, isobutyl alcohol, ethylene glycol, and propylene glycol can also be used. These water-soluble solvents can be used alone, in combination with one another, or further mixed with water to obtain a desired coating material.

The content of the solvent is not particularly limited, and may be 50.0% by mass or more and 99.5% by mass or less, relative to the total mass of the coating material for forming a magnetic layer.

Further, a surface conditioner, a defoaming agent, a thickening agent, and the like may be added to the coating material for forming a magnetic layer.

### <Formation of magnetic layer>

It is possible to use, as a method for applying the coating material for forming a magnetic layer onto the base, for example, a coating method such as bar coating, reverse coating, gravure coating, Microgravure (registered trademark) coating, die coating, dipping, spin coating, slit coating, or spray coating.

It is sufficient that the drying after the coating material is applied may be carried out under conditions in which a solvent component of the coating material for forming a magnetic layer is evaporated, and is preferably carried out at 100°C to 150°C for 3 to 30 minutes. If the solvent remains in the magnetic layer, the strength tends to decrease. Examples of the drying method include a hot air drying method, a heat drying method, a vacuum drying method, and an air drying method.

### (Cable)

An embodiment of a cable according to the present application will be described below. The cable according to this embodiment includes the aforementioned electromagnetic noise suppression sheet according to the embodiment of the present application. Examples of the cable according to this embodiment include communication cables such as coaxial cables, twisted pair cables, and multicore cables. In particular, coaxial cables are used for high frequency transmission and used as video cables.

Hereinafter, a coaxial cable, which is an example of the cable according to this embodiment, will be described. In the coaxial cable, the electromagnetic noise suppression sheet according to the present application is used as a magnetic sheath layer of the coaxial cable. By using the electromagnetic noise suppression sheet according to this application as the magnetic sheath layer of the coaxial cable, the electromagnetic noise suppression sheet according to this application can function as the electromagnetic noise suppression layer of the coaxial cable. In addition, by using the electromagnetic noise suppression sheet according to the present application as the magnetic sheath layer of the coaxial cable, it is possible to prevent a crack from forming in the magnetic sheath layer and prevent magnetic powder from falling off from a cutting surface obtained when the coaxial cable is cut.

Next, the coaxial cable in this embodiment will be described based on the drawings compared to a conventional coaxial cable.

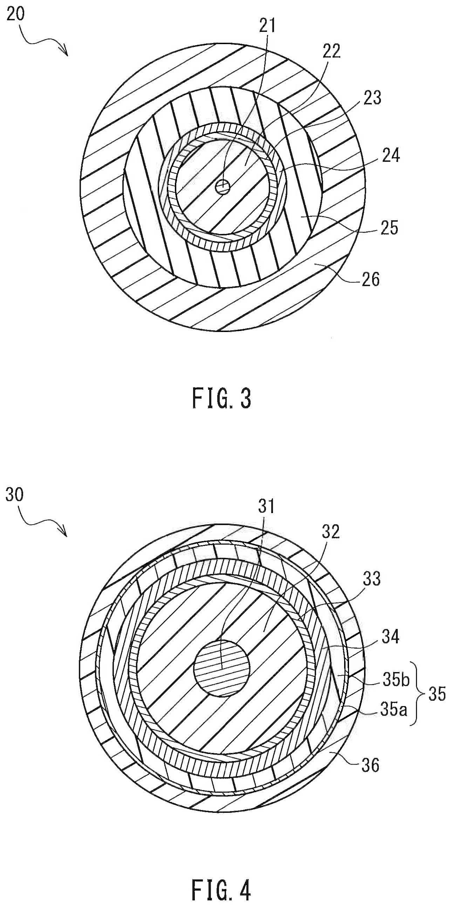

FIG. 3 is a schematic cross-sectional view showing an example of a conventional coaxial cable. In FIG. 3, a conventional coaxial cable 20 includes an inner conductor 21, an insulating layer 22, a metal foil 23, a metal braid 24, a magnetic sheath layer 25, and an outer coating layer 26. Details of each constituent member of the coaxial cable 20 are described in detail in Patent Document 2 (JP 2022-108557A).

The magnetic sheath layer 25 of the conventional coaxial cable 20 is formed as an extrusion molded body by extruding a magnetic sheath layer forming material, which is formed by dispersing magnetic powder in a polymer matrix material, onto an outer surface of a linear conductor constituted by the inner conductor 21, the insulating layer 22, the metal foil 23, and the metal braid 24, using the extrusion molding method. This increases the thickness of the magnetic sheath layer 25 and also increases the processing time. In addition, when the coaxial cable is cut, magnetic powder is likely to fall off from the cutting surface.

In contrast, FIG. 4 is a schematic cross-sectional view showing an example of the coaxial cable according to this embodiment. The coaxial cable 30 according to this embodiment includes an inner conductor 31, an insulating layer 32, a metal foil 33, a metal braid 34, a magnetic sheath layer 35, and an outer coating layer 36. The electromagnetic noise suppression sheet according to the present application is used as the magnetic sheath layer 35, and the magnetic sheath layer 35 is constituted by a base layer 35a and a magnetic layer 35b arranged on one side of the base layer 35a.

Although the magnetic layer 35b of the magnetic sheath layer 35 is disposed on the axial center side in FIG. 4, the base layer 35a may be placed on the axial center side.

The magnetic sheath layer 35 of the coaxial cable 30 according to this embodiment can be formed by wrapping the electromagnetic noise suppression sheet according to the present application around the outer surface of a linear conductor constituted by the inner conductor 31, the insulating layer 32, the metal foil 33, and the metal braid 34. This allows the magnetic sheath layer to be thin and can also shorten the processing time. In addition, it is possible to prevent magnetic powder from falling off from a cutting surface when the coaxial cable is cut.

In addition to the coaxial cable, the electromagnetic noise suppression sheet according to the present application can be used on uneven surfaces or corners of electronic devices that emit electromagnetic noise or electronic devices that need to shield from electromagnetic noise. Further, the electromagnetic noise suppression sheet according to the present application can also be used as an alternative to a ferrite core used in a cable for an electronic device.

### Examples

Hereinafter, the present application will be described in detail using examples. However, the present application is not limited to the following examples. In the following description, "parts" means "parts by mass", unless otherwise specified.

### (Example 1)

### <Preparation of coating material for forming magnetic layer>

A coating material A for forming a magnetic layer was prepared by mixing and dispersing the following components.
(1) Soft magnetic material (spherical carbonyl iron powder, product name "YW-3" manufactured by Jiangsu Tianyi Ultrafine Metal Powder Limited Company): 53.43 parts
(2) Amorphous polyester (a) (water-soluble polyester resin solution, product name "PLAS COAT Z-3310" manufactured by Goo Chemical, Co., Ltd., Tg: -20°C, solid content concentration: 25.0% by mass, solvent: water): 15.77 parts
(3) Amorphous polyester (b) (water-soluble polyester resin solution, product name "PLAS COAT Z-730" manufactured by Goo Chemical, Co., Ltd., Tg: 43°C, solid content concentration: 25.0% by mass, solvent: water): 10.51 parts
(4) Solvent (n-propyl alcohol): 10.00 parts
(5) Pure water: 10.29 parts

A mass ratio between the amorphous polyesters (a) and (b) in the coating material A for forming a magnetic layer was (a):(b) = 60:40. The volume content of the soft magnetic material relative to the total solid content of the coating material A for forming a magnetic layer was 60%.

### <Formation of magnetic layer>

Next, a PET film with a thickness of 12 µm (product name 'ESTER Film E5100' manufactured by Toyobo, Co., Ltd.) was used as the base, and the coating material A for forming a magnetic layer was applied to one of the main surfaces of the base using an applicator, and then dried at 120°C for 3 minutes. The resulting film was cut into a 150 mm square and pressed by a pressing machine at 50°C and 210 kg/cm² for 30 seconds to produce an electromagnetic noise suppression sheet of Example 1 having a magnetic layer formed on one main surface. The thickness of the magnetic layer was 38 µm, and the total thickness of the electromagnetic noise suppression sheet was 50 µm.

### (Example 2)

### <Preparation of coating material for forming magnetic layer>

A coating material B for forming a magnetic layer was prepared by mixing and dispersing the following components.
(1) Soft magnetic material (flat carbonyl iron powder, product name "YP" manufactured by Jiangsu Tianyi Ultrafine Metal Powder Limited Company): 50.43 parts
(2) Amorphous polyester (a) (water-soluble polyester resin solution, product name "PLAS COAT Z-3310" manufactured by Goo Chemical, Co., Ltd., Tg: -20°C, solid content concentration: 25.0% by mass, solvent: water): 30.63 parts
(3) Amorphous polyester (b) (water-soluble polyester resin solution, product name "PLAS COAT Z-730" manufactured by Goo Chemical, Co., Ltd., Tg: 43°C, solid content concentration: 25.0% by mass, solvent: water): 7.66 parts
(4) Solvent (n-propyl alcohol): 10.00 parts
(5) Pure water: 1.28 parts

A mass ratio between the amorphous polyesters (a) and (b) in the coating material B for forming a magnetic layer was (a):(b) = 80:20. The volume content of the soft magnetic material relative to the total solid content of the coating material B for forming a magnetic layer was 50%.

### <Formation of magnetic layer>

Next, an electromagnetic noise suppression sheet of Example 2 having a magnetic layer was produced in the same manner as in Example 1, except that the coating material B for forming a magnetic layer was used instead of the coating material A for forming a magnetic layer of Example 1. The thickness of the magnetic layer was 28 µm, and the total thickness of the electromagnetic noise suppression sheet was 40 µm.

### (Example 3)

### <Preparation of coating material for forming magnetic layer>

A coating material C for forming a magnetic layer was prepared by mixing and dispersing the following components.
(1) Soft magnetic material (spherical carbonyl iron powder, product name "YW-5" manufactured by Jiangsu Tianyi Ultrafine Metal Powder Limited Company): 53.01 parts
(2) Amorphous polyester (a) (water-soluble polyester resin solution, product name "PLAS COAT Z-3310" manufactured by Goo Chemical, Co., Ltd., Tg: -20°C, solid content concentration: 25.0% by mass, solvent: water): 19.56 parts
(3) Amorphous polyester (b) (water-soluble polyester resin solution, product name "PLAS COAT Z-730" manufactured by Goo Chemical, Co., Ltd., Tg: 43°C, solid content concentration: 25.0% by mass, solvent: water): 8.38 parts
(4) Oxazoline group-containing polymer (product name "EPOCROS WS-500" manufactured by Nippon Shokubai Co., Ltd., solid content concentration: 40.0% by mass, solvent: water): 2.00 parts
(5) Solvent (n-propyl alcohol): 10.00 parts
(6) Pure water: 7.04 parts

A mass ratio between the amorphous polyesters (a) and (b) in the coating material C for forming a magnetic layer was (a):(b) = 70:30. The volume content of the soft magnetic material relative to the total solid content of the coating material C for forming a magnetic layer was 60%.

### <Formation of magnetic layer>

Next, an electromagnetic noise suppression sheet of Example 3 having a magnetic layer was produced in the same manner as in Example 1, except that the coating material C for forming a magnetic layer was used instead of the coating material A for forming a magnetic layer of Example 1. The thickness of the magnetic layer was 36 µm, and the total thickness of the electromagnetic noise suppression sheet was 48 µm.

### (Example 4)

### <Preparation of coating material for forming magnetic layer>

A coating material D for forming a magnetic layer was prepared by mixing and dispersing the following components.
(1) Soft magnetic material (spherical carbonyl iron powder, product name "YW-3" manufactured by Jiangsu Tianyi Ultrafine Metal Powder Limited Company): 53.43 parts
(2) Amorphous polyester (a) (water-soluble polyester resin solution, product name "PLAS COAT Z-3310" manufactured by Goo Chemical, Co., Ltd., Tg: -20°C, solid content concentration: 25.0% by mass, solvent: water): 14.46 parts
(3) Amorphous polyester (b) (water-soluble polyester resin solution, product name "PLAS COAT Z-730" manufactured by Goo Chemical, Co., Ltd., Tg: 43°C, solid content concentration: 25.0% by mass, solvent: water): 11.83 parts
(4) Carbodiimide group-containing polymer (product name "CARBODILITE SV-02" manufactured by Nisshinbo Chemical Inc., solid content concentration: 40.0% by mass, solvent: water): 2.00 parts
(5) Solvent (n-propyl alcohol): 10.00 parts
(6) Pure water: 8.29 parts

A mass ratio between the amorphous polyesters (a) and (b) in the coating material D for forming a magnetic layer was (a):(b) = 55:45. The volume content of the soft magnetic material relative to the total solid content of the coating material D for forming a magnetic layer was 60%.

### <Formation of magnetic layer>

Next, an electromagnetic noise suppression sheet of Example 4 having a magnetic layer was produced in the same manner as in Example 1, except that the coating material D for forming a magnetic layer was used instead of the coating material A for forming a magnetic layer of Example 1. The thickness of the magnetic layer was 38 µm, and the total thickness of the electromagnetic noise suppression sheet was 50 µm.

### (Example 5)

### <Preparation of coating material for forming magnetic layer>

A coating material E for forming a magnetic layer was prepared by mixing and dispersing the following components.
(1) Soft magnetic material (spherical Mn-Zn ferrite powder, product name "BSF-547" manufactured by Toda Kogyo Corp.): 53.62 parts
(2) Amorphous polyester (a) (water-soluble polyester resin solution, product name "PLAS COAT Z-3310" manufactured by Goo Chemical, Co., Ltd., Tg: -20°C, solid content concentration: 25.0% by mass, solvent: water): 22.97 parts
(3) Amorphous polyester (b) (water-soluble polyester resin solution, product name "PLAS COAT Z-730" manufactured by Goo Chemical, Co., Ltd., Tg: 43°C, solid content concentration: 25.0% by mass, solvent: water): 2.55 parts
(4) Solvent (n-propyl alcohol): 10.00 parts
(5) Pure water: 10.86 parts

A mass ratio between the amorphous polyesters (a) and (b) in the coating material E for forming a magnetic layer was (a):(b) = 90:10. The volume content of the soft magnetic material relative to the total solid content of the coating material E for forming a magnetic layer was 70%.

### <Formation of magnetic layer>

Next, an electromagnetic noise suppression sheet of Example 5 having a magnetic layer was produced in the same manner as in Example 1, except that the coating material E for forming a magnetic layer was used instead of the coating material A for forming a magnetic layer of Example 1. The thickness of the magnetic layer was 40 µm, and the total thickness of the electromagnetic noise suppression sheet was 52 µm.

### (Example 6)

An electromagnetic noise suppression sheet of Example 6 was produced in the same manner as in Example 3, except that the thickness of the magnetic layer was changed to 5 µm, and the total thickness of the electromagnetic noise suppression sheet was changed to 17 µm.

### (Example 7)

An electromagnetic noise suppression sheet of Example 7 was produced in the same manner as in Example 3, except that the thickness of the magnetic layer was changed to 70 µm, and the total thickness of the electromagnetic noise suppression sheet was changed to 82 µm.

### (Example 8)

### <Preparation of coating material for forming magnetic layer>

A coating material F for forming a magnetic layer was prepared by mixing and dispersing the following components.
(1) Soft magnetic material (spherical carbonyl iron powder, product name "YW-5" manufactured by Jiangsu Tianyi Ultrafine Metal Powder Limited Company): 53.01 parts
(2) Amorphous polyester (a) (water-soluble polyester resin solution, product name "PLAS COAT Z-3310" manufactured by Goo Chemical, Co., Ltd., Tg: -20°C, solid content concentration: 25.0% by mass, solvent: water): 27.39 parts
(3) Amorphous polyester (b) (water-soluble polyester resin solution, product name "PLAS COAT Z-730" manufactured by Goo Chemical, Co., Ltd., Tg: 43°C, solid content concentration: 25.0% by mass, solvent: water): 0.56 parts
(4) Oxazoline group-containing polymer (product name "EPOCROS WS-500" manufactured by Nippon Shokubai Co., Ltd., solid content concentration: 40.0% by mass, solvent: water): 0.75 parts
(5) Solvent (n-propyl alcohol): 10.00 parts
(6) Pure water: 8.29 parts

A mass ratio between the amorphous polyesters (a) and (b) in the coating material F for forming a magnetic layer was (a):(b) = 98:2. The volume content of the soft magnetic material relative to the total solid content of the coating material F for forming a magnetic layer was 60%.

### <Formation of magnetic layer>

Next, an electromagnetic noise suppression sheet of Example 8 having a magnetic layer was produced in the same manner as in Example 1, except that the coating material F for forming a magnetic layer was used instead of the coating material A for forming a magnetic layer of Example 1. The thickness of the magnetic layer was 38 µm, and the total thickness of the electromagnetic noise suppression sheet was 50 µm.

### (Example 9)

### <Preparation of coating material for forming magnetic layer>

A coating material G for forming a magnetic layer was prepared by mixing and dispersing the following components.
(1) Soft magnetic material (spherical carbonyl iron powder, product name "YW-5" manufactured by Jiangsu Tianyi Ultrafine Metal Powder Limited Company): 53.01 parts
(2) Amorphous polyester (a) (water-soluble polyester resin solution, product name "PLAS COAT Z-3310" manufactured by Goo Chemical, Co., Ltd., Tg: -20°C, solid content concentration: 25.0% by mass, solvent: water): 8.38 parts
(3) Amorphous polyester (b) (water-soluble polyester resin solution, product name "PLAS COAT Z-730" manufactured by Goo Chemical, Co., Ltd., Tg: 43°C, solid content concentration: 25.0% by mass, solvent: water): 19.56 parts
(4) Oxazoline group-containing polymer (product name "EPOCROS WS-500" manufactured by Nippon Shokubai Co., Ltd., solid content concentration: 40.0% by mass, solvent: water): 0.75 parts
(5) Solvent (n-propyl alcohol): 10.00 parts
(6) Pure water: 8.30 parts

A mass ratio between the amorphous polyesters (a) and (b) in the coating material G for forming a magnetic layer was (a):(b) = 30:70. The volume content of the soft magnetic material relative to the total solid content of the coating material G for forming a magnetic layer was 60%.

### <Formation of magnetic layer>

Next, an electromagnetic noise suppression sheet of Example 9 having a magnetic layer was produced in the same manner as in Example 1, except that the coating material G for forming a magnetic layer was used instead of the coating material A for forming a magnetic layer of Example 1. The thickness of the magnetic layer was 38 µm, and the total thickness of the electromagnetic noise suppression sheet was 50 µm.

### (Example 10)

### <Preparation of coating material for forming magnetic layer>

A coating material H for forming a magnetic layer was prepared by mixing and dispersing the following components.
(1) Soft magnetic material (spherical carbonyl iron powder, product name "YW-5" manufactured by Jiangsu Tianyi Ultrafine Metal Powder Limited Company): 53.01 parts
(2) Amorphous polyurethane (a) (water-soluble polyurethane resin solution, product name "USC-2101" manufactured by Fujikura Kasei, Co., Ltd., Tg: -33°C, solid content concentration: 35.0% by mass, solvent: water): 13.97 parts
(3) Amorphous polyester (b) (water-soluble polyester resin solution, product name "PLAS COAT Z-730" manufactured by Goo Chemical, Co., Ltd., Tg: 43°C, solid content concentration: 25.0% by mass, solvent: water): 8.38 parts
(4) Oxazoline group-containing polymer (product name "EPOCROS WS-500" manufactured by Nippon Shokubai Co., Ltd., solid content concentration: 40.0% by mass, solvent: water): 0.75 parts
(5) Solvent (n-propyl alcohol): 10.00 parts
(6) Pure water: 13.89 parts

A mass ratio between the amorphous polyesters (a) and (b) in the coating material H for forming a magnetic layer was (a):(b) = 70:30. The volume content of the soft magnetic material relative to the total solid content of the coating material H for forming a magnetic layer was 60%.

### <Formation of magnetic layer>

Next, an electromagnetic noise suppression sheet of Example 10 having a magnetic layer was produced in the same manner as in Example 1, except that the coating material H for forming a magnetic layer was used instead of the coating material A for forming a magnetic layer of Example 1. The thickness of the magnetic layer was 38 µm, and the total thickness of the electromagnetic noise suppression sheet was 50 µm.

### (Example 11)

### <Preparation of coating material for forming magnetic layer>

A coating material I for forming a magnetic layer was prepared by mixing and dispersing the following components.
(1) Soft magnetic material (spherical carbonyl iron powder, product name "YW-5" manufactured by Jiangsu Tianyi Ultrafine Metal Powder Limited Company): 53.01 parts
(2) Amorphous acrylic resin (a) (water-soluble acrylic resin solution, product name "ABH-6201" manufactured by Fujikura Kasei, Co., Ltd., Tg: -6°C, solid content concentration: 43.0% by mass, solvent: water): 13.00 parts
(3) Amorphous polyester (b) (water-soluble polyester resin solution, product name "PLAS COAT Z-730" manufactured by Goo Chemical, Co., Ltd., Tg: 43°C, solid content concentration: 25.0% by mass, solvent: water): 5.59 parts
(4) Oxazoline group-containing polymer (product name "EPOCROS WS-500" manufactured by Nippon Shokubai Co., Ltd., solid content concentration: 40.0% by mass, solvent: water): 0.75 parts
(5) Solvent (n-propyl alcohol): 10.00 parts
(6) Pure water: 17.65 parts

A mass ratio between the amorphous polyesters (a) and (b) in the coating material I for forming a magnetic layer was (a):(b) = 80:20. The volume content of the soft magnetic material relative to the total solid content of the coating material I for forming a magnetic layer was 60%.

### <Formation of magnetic layer>

Next, an electromagnetic noise suppression sheet of Example 11 having a magnetic layer was produced in the same manner as in Example 1, except that the coating material I for forming a magnetic layer was used instead of the coating material A for forming a magnetic layer of Example 1. The thickness of the magnetic layer was 38 µm, and the total thickness of the electromagnetic noise suppression sheet was 50 µm.

### (Example 12)

### <Preparation of coating material for forming magnetic layer>

A coating material J for forming a magnetic layer was prepared by mixing and dispersing the following components.
(1) Soft magnetic material (spherical carbonyl iron powder, product name "YW-5" manufactured by Jiangsu Tianyi Ultrafine Metal Powder Limited Company): 53.01 parts
(2) Amorphous polyester-polyurethane (a) (polyester-polyurethane resin solution, product name "VYLON UR-6100" manufactured by Toyobo MC Corporation, Tg: -30°C, solid content concentration: 45.0% by mass, solvent: cyclohexanone/aromatic solvent/isophorone = 40% by mass/40% by mass/20% by mass): 7.76 parts
(3) Amorphous polyester-polyurethane (b) (polyester-polyurethane resin solution, product name "VYLON UR-3600" manufactured by Toyobo MC Corporation, Tg: 40°C, solid content concentration: 40.0% by mass, solvent: methyl ethyl ketone/toluene = 63% by mass/37% by mass): 8.73 parts
(4) Isocyanate-based curing agent (product name "Coronate HX" manufactured by Tosoh Corporation): 0.2 parts
(5) Solvent (methyl ethyl ketone): 15.00 parts
(6) Solvent (toluene): 15.30 parts

A mass ratio between the amorphous polyester-polyurethanes (a) and (b) in the coating material J for forming a magnetic layer was (a):(b) = 50:50. The volume content of the soft magnetic material relative to the total solid content of the coating material J for forming a magnetic layer was 60%.

### <Formation of magnetic layer>

Next, an electromagnetic noise suppression sheet of Example 12 having a magnetic layer was produced in the same manner as in Example 1, except that the coating material J for forming a magnetic layer was used instead of the coating material A for forming a magnetic layer of Example 1. The thickness of the magnetic layer was 38 µm, and the total thickness of the electromagnetic noise suppression sheet was 50 µm.

### (Comparative Example 1)

### <Preparation of coating material for forming magnetic layer>

A coating material K for forming a magnetic layer was prepared by mixing and dispersing the following components.
(1) Soft magnetic material (spherical carbonyl iron powder, product name "YW-3" manufactured by Jiangsu Tianyi Ultrafine Metal Powder Limited Company): 53.43 parts
(2) Amorphous polyester (b) (water-soluble polyester resin solution, product name "PLAS COAT Z-730" manufactured by Goo Chemical, Co., Ltd., Tg: 43°C, solid content concentration: 25.0% by mass, solvent: water): 26.29 parts
(3) Solvent (n-propyl alcohol): 10.00 parts
(4) Pure water: 10.28 parts

In the coating material K for forming a magnetic layer, only the amorphous polyester (b) was used as the amorphous resin, and the volume content of the soft magnetic material relative to the total solid content of the coating material K for forming a magnetic layer was 60%.

### <Formation of magnetic layer>

Next, an electromagnetic noise suppression sheet of Comparative Example 1 having a magnetic layer was produced in the same manner as in Example 1, except that the coating material K for forming a magnetic layer was used instead of the coating material A for forming a magnetic layer of Example 1. The thickness of the magnetic layer was 38 µm, and the total thickness of the electromagnetic noise suppression sheet was 50 µm.

### (Comparative Example 2)

### <Preparation of coating material for forming magnetic layer>

A coating material L for forming a magnetic layer was prepared by mixing and dispersing the following components.
(1) Soft magnetic material (spherical carbonyl iron powder, product name "YW-3" manufactured by Jiangsu Tianyi Ultrafine Metal Powder Limited Company): 53.43 parts
(2) Amorphous polyester (a) (water-soluble polyester resin solution, product name "PLAS COAT Z-3310" manufactured by Goo Chemical, Co., Ltd., Tg: -20°C, solid content concentration: 25.0% by mass, solvent: water): 26.29 parts
(3) Solvent (n-propyl alcohol): 10.00 parts
(4) Pure water: 10.28 parts

In the coating material L for forming a magnetic layer, only the amorphous polyester (a) was used as the amorphous resin, and the volume content of the soft magnetic material relative to the total solid content of the coating material L for forming a magnetic layer was 60%.

### <Formation of magnetic layer>

Next, an electromagnetic noise suppression sheet of Comparative Example 2 having a magnetic layer was produced in the same manner as in Example 1, except that the coating material L for forming a magnetic layer was used instead of the coating material A for forming a magnetic layer of Example 1. The thickness of the magnetic layer was 38 µm, and the total thickness of the electromagnetic noise suppression sheet was 50 µm.

### (Comparative Example 3)

### <Preparation of coating material for forming magnetic layer>

A coating material M for forming a magnetic layer was prepared by mixing and dispersing the following components.
(1) Soft magnetic material (spherical carbonyl iron powder, product name "YW-5" manufactured by Jiangsu Tianyi Ultrafine Metal Powder Limited Company): 53.01 parts
(2) Amorphous polyester-polyurethane (a) (polyester-polyurethane resin solution, product name "VYLON UR-6100" manufactured by Toyobo, Co., Ltd., Tg: -30°C, solid content concentration: 45.0% by mass, solvent: cyclohexanone/aromatic solvent/isophorone = 40% by mass/40% by mass/20% by mass): 7.76 parts
(3) Amorphous polyester (b) (polyester resin solution, product name "VYLON 500" manufactured by Toyobo MC Corporation, Tg: 4°C, solid content concentration: 30.0% by mass, solvent: methyl ethyl ketone): 11.65 parts
(4) Isocyanate-based curing agent (product name "Coronate HX" manufactured by Tosoh Corporation): 0.2 parts
(5) Solvent (methyl ethyl ketone): 15.00 parts
(6) Solvent (toluene): 12.38 parts

A mass ratio between the amorphous resins (a) and (b) in the coating material M for forming a magnetic layer was (a):(b) = 50:50. The volume content of the soft magnetic material relative to the total solid content of the coating material M for forming a magnetic layer was 60%.

### <Formation of magnetic layer>

Next, an electromagnetic noise suppression sheet of Comparative Example 3 having a magnetic layer was produced in the same manner as in Example 1, except that the coating material M for forming a magnetic layer was used instead of the coating material A for forming a magnetic layer of Example 1. The thickness of the magnetic layer was 38 µm, and the total thickness of the electromagnetic noise suppression sheet was 50 µm.

### (Comparative Example 4)

### <Preparation of coating material for forming magnetic layer>

A coating material N for forming a magnetic layer was prepared by mixing and dispersing the following components.
(1) Soft magnetic material (spherical carbonyl iron powder, product name "YW-5" manufactured by Jiangsu Tianyi Ultrafine Metal Powder Limited Company): 53.01 parts
(2) Amorphous polyester (a) (polyester resin solution, product name "VYLON 500" manufactured by Toyobo MC Corporation, Tg: 4°C, solid content concentration: 30.0% by mass, solvent: methyl ethyl ketone): 7.76 parts
(3) Amorphous polyester-polyurethane (b) (polyester-polyurethane resin solution, product name "VYLON UR-3600" manufactured by Toyobo MC Corporation, Tg: 40°C, solid content concentration: 40.0% by mass, solvent: methyl ethyl ketone/toluene = 63% by mass/37% by mass): 8.73 parts
(4) Isocyanate-based curing agent (product name "Coronate HX" manufactured by Tosoh Corporation): 0.2 parts
(5) Solvent (methyl ethyl ketone): 15.00 parts
(6) Solvent (toluene): 11.41 parts

A mass ratio between the amorphous resins (a) and (b) in the coating material N for forming a magnetic layer was (a):(b) = 50:50. The volume content of the soft magnetic material relative to the total solid content of the coating material N for forming a magnetic layer was 60%.

### <Formation of magnetic layer>

Next, an electromagnetic noise suppression sheet of Comparative Example 4 having a magnetic layer was produced in the same manner as in Example 1, except that the coating material N for forming a magnetic layer was used instead of the coating material A for forming a magnetic layer of Example 1. The thickness of the magnetic layer was 38 µm, and the total thickness of the electromagnetic noise suppression sheet was 50 µm.

The electromagnetic noise suppression sheets of Examples 1 to 12 and Comparative Examples 1 to 4 were evaluated as follows.

### <Adhesion>

First, using a cutter knife, eleven cutting lines were made at 1 mm intervals lengthwise and widthwise into a magnetic layer surface of the produced electromagnetic noise suppression sheet such that the lines penetrated the layer until reaching the base, resulting in formation of 100 squares in a grid pattern. Cellophane tape was then firmly pressed onto the grid pattern, and the tape was quickly peeled off from the edge at an angle of 45°. The state of the grid pattern was observed, and the adhesion of the magnetic layer of the electromagnetic noise suppression sheet was evaluated as follows.
Evaluation A: The magnetic layer did not peel in any of the squares.
Evaluation B: The magnetic layer peeled at less than 5% of the cut intersections and the portions of the squares.
Evaluation C: The magnetic layer peeled at 5% or more of the cut intersections and the portions of the squares.

### <Bending properties>

The produced electromagnetic noise suppression sheet was cut into a tape-like piece with a size of 10 mm × 100 mm, and a base surface of the tape-like piece was wrapped around a stainless steel metal rod such that the base surface comes into contact with an outer circumferential surface of the metal rod over approximately 360°, and the resulting metal rod was held in this state for 1 minute. Thereafter, the magnetic layer surface of the tape-like piece wrapped around the metal rod was observed under a microscope, and bending properties of the magnetic layer of the electromagnetic noise suppression sheet were evaluated as follows.
Evaluation A: The magnetic layer did not peel off and crack when the tape-like piece was wrapped around a stainless steel rod with a diameter of 1 mm.
Evaluation B: The magnetic layer did not peel off and crack when the tape-like piece was wrapped around a stainless steel rod with a diameter of 2 mm.
Evaluation C: The magnetic layer peeled off or cracked when the tape-like piece was wrapped around a stainless steel rod with a diameter of 2 mm.

### <Tackiness>

Two 10 cm square pieces of the produced electromagnetic noise suppression sheet were prepared and stacked such that the magnetic layer surface of one sheet and the base surface of the other sheet were in contact with each other, and a weight with a diameter of 1 cm was pressed against the resulting stacked sheets under a load of 1 kg for 30 seconds. Then, the adhesion state of the stacked sheets was observed, and the tackiness of the magnetic layer of the electromagnetic noise suppression sheet was evaluated as follows.
Evaluation A: The lower sheet did not adhere to the upper sheet when only the upper sheet of the stacked sheets was lifted.
Evaluation B: The lower sheet adhered to the upper sheet when only the upper sheet of the stacked sheets was lifted, but the lower sheet fell off under its own weight in less than 5 seconds.
Evaluation C: The lower sheet adhered to the upper sheet when only the upper sheet of the stacked sheets was lifted, and the lower sheet did not fall for 5 seconds or longer.

### <Electromagnetic noise suppression effects>

Magnetic noise suppression effects of the produced electromagnetic noise suppression sheet were confirmed by evaluating the internal decoupling ratio (Rda) using an intra-decoupling ratio measurement system (conforming to IEC62333-2) using a vector network analyzer and a loop antenna. Specifically, the internal decoupling ratio at 100 MHz and the frequency at the maximum internal decoupling ratio from 100 MHz to 10 GHz were measured.

The above results are shown in Tables 1 and 2, along with the constituent materials of the magnetic layers of the produced electromagnetic noise suppression sheets.

**[Table 1]**

| | Ex. 1 | Ex. 2 | Ex. 3 | Ex. 4 | Ex. 5 | Ex. 6 | Ex. 7 | Ex. 8 |
|---|---|---|---|---|---|---|---|---|
| Magnetic Material | carbonyl iron | carbonyl iron | carbonyl iron | carbonyl iron | Mn-Zn Ferrite | carbonyl iron | carbonyl iron | carbonyl iron |
| Resin (a) | PLAS COAT Z-3310 | PLAS COAT Z-3310 | PLAS COAT Z-3310 | PLAS COAT Z-3310 | PLAS COAT Z-3310 | PLAS COAT Z-3310 | PLAS COAT Z-3310 | PLAS COAT Z-3310 |
| Resin (b) | PLAS COAT Z-730 | PLAS COAT Z-730 | PLAS COAT Z-730 | PLAS COAT Z-730 | PLAS COAT Z-730 | PLAS COAT Z-730 | PLAS COAT Z-730 | PLAS COAT Z-730 |
| Amide Bond (crosslinked portion) | No | No | Yes | Yes | No | Yes | Yes | Yes |
| Adhesion | B | B | A | A | B | A | A | B |
| Bending Properties | A | B | A | A | B | A | B | A |
| Tackiness | A | B | A | A | B | A | B | B |
| Rda/100MHz | -0.5 dB | -0.4 dB | -0.5 dB | -0.4 dB | -0.3 dB | -0.1 dB | -0.7 dB | -0.5 dB |
| Max. Rda | -2.7 dB | -3.5 dB | -2.8 dB | -3.1 dB | -1.8 dB | -1.6 dB | -3.2 dB | -3.1 dB |
| Max. Rda Frequency | 2.2 GHz | 3.2 GHz | 2.4 GHz | 2.3 GHz | 0.5 GHz | 2.8 GHz | 1.7 GHz | 2.4 GHz |

**[Table 2]**

| | Ex. 9 | Ex. 10 | Ex. 11 | Ex. 12 | Comp. Ex. 1 | Comp. Ex. 2 | Comp. Ex. 3 | Comp. Ex. 4 |
|---|---|---|---|---|---|---|---|---|
| Magnetic Material | carbonyl iron | carbonyl iron | carbonyl iron | carbonyl iron | carbonyl iron | carbonyl iron | carbonyl iron | carbonyl iron |
| Resin (a) | PLAS COAT Z-3310 | USC-2101 | ABH-6201 | VYLON UR-6100 | - | PLAS COAT Z-3310 | VYLON UR-6100 | VYLON 500 |
| Resin (b) | PLAS COAT Z-730 | PLAS COAT Z-730 | PLAS COAT Z-730 | VYLON UR-3600 | PLAS COAT Z-730 | - | VYLON 500 | VYLON UR-3600 |
| Amide Bond (crosslinked portion) | Yes | Yes | Yes | No | No | No | No | No |
| Adhesion | A | A | B | B | C | A | A | C |
| Bending Properties | B | A | A | A | C | A | A | C |
| Tackiness | A | B | A | A | A | C | C | A |
| Rda/100MHz | -0.5 dB | -0.5 dB | -0.5 dB | -0.4 dB | -0.5 dB | -0.4 dB | -0.4 dB | -0.4 dB |
| Max. Rda | -3.1 dB | -3.1 dB | -3.1 dB | -3.0 dB | -2.6 dB | -2.7 dB | -3.0 dB | -3.0 dB |
| Max. Rda Frequency | 2.4 GHz | 2.3 GHz | 2.3 GHz | 2.3 GHz | 2.2 GHz | 2.3 GHz | 2.2 GHz | 2.2 GHz |

Tables 1 and 2 show that the electromagnetic noise suppression sheets of Examples 1 to 12 were effective in suppressing magnetic noise, and also provided good results in terms of adhesion, bending properties, and tackiness. On the other hand, it was found that the electromagnetic noise suppression sheets of Comparative Examples 1 to 4 had electromagnetic noise suppression effects, but Comparative Examples 1 and 4, in which the magnetic layer did not contain the amorphous resin (a) having a glass transition temperature of 0°C or lower, exhibited poor adhesion and bending properties. Comparative Examples 2 and 3, in which the magnetic layer did not contain the amorphous resin (b) having a glass transition temperature of 10°C or higher, exhibited poor tackiness.

With regard to the embodiments of the present application including Examples 1 to 12 described above, the following supplementary embodiments will be disclosed.
(Supplementary Embodiment 1) An electromagnetic noise suppression sheet comprising:
   a base; and
   a magnetic layer,
   wherein the magnetic layer contains a magnetic material and a binder, and
   the binder contains an amorphous resin (A) having a glass transition temperature of -50°C to 0°C and an amorphous resin (B) having a glass transition temperature of 10°C or higher.
(Supplementary Embodiment 2) The electromagnetic noise suppression sheet according to Supplementary Embodiment 1,
   wherein the amorphous resin (A) is an amorphous polyester (a) having a glass transition temperature of -50°C to 0°C, and the amorphous resin (B) is an amorphous polyester (b) having a glass transition temperature of 10°C or higher.
(Supplementary Embodiment 3) The electromagnetic noise suppression sheet according to Supplementary Embodiment 2,
   wherein a mass ratio between the amorphous polyester (a) and the amorphous polyester (b) is (a):(b) = 95:5 to 35:65.
(Supplementary Embodiment 4) The electromagnetic noise suppression sheet according to Supplementary Embodiment 2,
   wherein a mass ratio between the amorphous polyester (a) and the amorphous polyester (b) is (a):(b) = 90:10 to 50:50.
(Supplementary Embodiment 5) The electromagnetic noise suppression sheet according to any one of Supplementary Embodiments 2 to 4,
   wherein at least one of the amorphous polyester (a) and the amorphous polyester (b) contains a crosslinked portion crosslinked by an amide bond.
(Supplementary Embodiment 6) The electromagnetic noise suppression sheet according to any one of Supplementary Embodiments 1 to 5,
   wherein a total amount of the amorphous resin (A) and the amorphous resin (B) is 90% by mass or more, relative to a total amount of the binder.
(Supplementary Embodiment 7) The electromagnetic noise suppression sheet according to any one of Supplementary Embodiments 1 to 6,
   wherein the magnetic material includes a soft magnetic material.
(Supplementary Embodiment 8) The electromagnetic noise suppression sheet according to Supplementary Embodiment 7,
   wherein the soft magnetic material is carbonyl iron.
(Supplementary Embodiment 9) The electromagnetic noise suppression sheet according to Supplementary Embodiment 7 or 8,
   wherein a volume content of the soft magnetic material contained in the magnetic layer is 30% to 80%.
(Supplementary Embodiment 10) The electromagnetic noise suppression sheet according to any one of Supplementary Embodiments 1 to 9,
   wherein the base is a resin film.
(Supplementary Embodiment 11) The electromagnetic noise suppression sheet according to any one of Supplementary Embodiments 1 to 10 further comprising:
   a metal layer.
(Supplementary Embodiment 12) The electromagnetic noise suppression sheet according to any one of Supplementary Embodiments 1 to 11,
   wherein the electromagnetic noise suppression sheet has an overall thickness of 10 to 85 µm.
(Supplementary Embodiment 13) A method for manufacturing the electromagnetic noise suppression sheet according to any one of Supplementary Embodiments 1 to 12, the method including:
   a step of producing a coating material for forming a magnetic layer by mixing, together with a solvent, a magnetic material, an amorphous resin (A) having a glass transition temperature of -50°C to 0°C, and an amorphous resin (B) having a glass transition temperature of 10°C or higher, and
   a step of applying the coating material for forming a magnetic layer to the base and drying the coating material.
(Supplementary Embodiment 14) The method for manufacturing the electromagnetic noise suppression sheet according to Supplementary Embodiment 13,
   wherein at least one resin selected from the amorphous resin (A) and the amorphous resin (B) that are contained in the coating material for forming a magnetic layer has a carboxyl group.
(Supplementary Embodiment 15) The method for manufacturing the electromagnetic noise suppression sheet according to Supplementary Embodiment 14,
   wherein the coating material for forming a magnetic layer further contains, as a crosslinking agent, a resin having at least one selected from an oxazoline group and a carbodiimide group.
(Supplementary Embodiment 16) The method for manufacturing the electromagnetic noise suppression sheet according to any one of Supplementary Embodiments 13 to 15,
   wherein the solvent contained in the coating material for forming a magnetic layer is at least one selected from water and a water-soluble solvent.
(Supplementary Embodiment 17) A cable comprising:
   the electromagnetic noise suppression sheet according to any one of Supplementary Embodiments 1 to 12.

The invention may be embodied in forms other than the embodiments described above. The embodiments disclosed in this application are merely examples and the present invention is not limited to these embodiments. The scope of the present application should be construed in view of the appended claims, rather than the foregoing description, and all changes that come within the meaning and range of equivalency of the claims are intended to be embraced therein.

### Description of Reference Numerals

- 10, 10': Electromagnetic noise suppression sheet
- 11: Base
- 12: Magnetic layer
- 13: Metal layer
- 20, 30: Coaxial cable
- 21, 31: Inner conductor
- 22, 32: Insulating layer
- 23, 33: Metal foil
- 24, 34: Metal braid
- 25, 35: Magnetic sheath layer
- 35a: Base layer
- 35b: Magnetic layer
- 26, 36: Outer coating layer

## Claims

1. An electromagnetic noise suppression sheet comprising:
a base; and
a magnetic layer,
wherein the magnetic layer contains a magnetic material and a binder, and
the binder contains an amorphous resin (A) having a glass transition temperature of -50°C to 0°C and an amorphous resin (B) having a glass transition temperature of 10°C or higher.

2. The electromagnetic noise suppression sheet according to claim 1,
wherein the amorphous resin (A) is an amorphous polyester (a) having a glass transition temperature of -50°C to 0°C, and the amorphous resin (B) is an amorphous polyester (b) having a glass transition temperature of 10°C or higher.

3. The electromagnetic noise suppression sheet according to claim 2,
wherein a mass ratio between the amorphous polyester (a) and the amorphous polyester (b) is (a):(b) = 95:5 to 35:65.

4. The electromagnetic noise suppression sheet according to claim 2,
wherein a mass ratio between the amorphous polyester (a) and the amorphous polyester (b) is (a):(b) = 90:10 to 50:50.

5. The electromagnetic noise suppression sheet according to claim 2,
wherein at least one of the amorphous polyester (a) and the amorphous polyester (b) contains a crosslinked portion crosslinked by an amide bond.

6. The electromagnetic noise suppression sheet according to claim 1,
wherein a total amount of the amorphous resin (A) and the amorphous resin (B) is 90% by mass or more, relative to a total amount of the binder.

7. The electromagnetic noise suppression sheet according to claim 1,
wherein the magnetic material includes a soft magnetic material.

8. The electromagnetic noise suppression sheet according to claim 7,
wherein the soft magnetic material is carbonyl iron.

9. The electromagnetic noise suppression sheet according to claim 7,
wherein a volume content of the soft magnetic material contained in the magnetic layer is 30% to 80%.

10. The electromagnetic noise suppression sheet according to claim 1,
wherein the base is a resin film.

11. The electromagnetic noise suppression sheet according to claim 1, further comprising
a metal layer.

12. The electromagnetic noise suppression sheet according to claim 1,
wherein the electromagnetic noise suppression sheet has an overall thickness of 10 to 85 µm.

13. A method for manufacturing the electromagnetic noise suppression sheet according to any one of claims 1 to 12, the method comprising:
a step of producing a coating material for forming a magnetic layer by mixing, together with a solvent, a magnetic material, an amorphous resin (A) having a glass transition temperature of -50°C to 0°C, and an amorphous resin (B) having a glass transition temperature of 10°C or higher; and
a step of applying the coating material for forming a magnetic layer to the base and drying the coating material.

14. The method for manufacturing the electromagnetic noise suppression sheet according to claim 13,
wherein at least one resin selected from the amorphous resin (A) and the amorphous resin (B) that are contained in the coating material for forming a magnetic layer has a carboxyl group.

15. The method for manufacturing the electromagnetic noise suppression sheet according to claim 14,
wherein the coating material for forming a magnetic layer further contains, as a crosslinking agent, a resin having at least one selected from an oxazoline group and a carbodiimide group.

16. The method for manufacturing the electromagnetic noise suppression sheet according to claim 13,
wherein the solvent contained in the coating material for forming a magnetic layer is at least one selected from water and a water-soluble solvent.

17. A cable comprising
the electromagnetic noise suppression sheet according to any one of claims 1 to 12.
